# EUROPÄISCHE PATENTANMELDUNG

(11) **EP 0 790 709 A1**
(43) Veröffentlichungstag der Anmeldung: **20.08.1997**
(21) Anmeldenummer: 97100290.2
(22) Anmeldetag: 10.01.1997
(51) Int. Cl.: H03M 1/70

(54) **Verfahren und Vorrichtung zur Wandlung eines digitalen Audiosignales**

(30) Priorität: 15.02.1996 CH 388/96
(71) Anmelder: STUDER Professional Audio AG, CH-8105 Regensdorf ZH (CH)
(72) Erfinder: Gehri, Silvio, 8604 Volketswil (CH)

(57) **Zusammenfassung**

Die Erfindung betrifft ein Verfahren zur Wandlung eines digitalen Audiosignales in ein analoges Signal. Um die Auflösung und den Störgeräuschabstand bei der Wandlung erhöhen zu können, wird das digitale Signal zur Wandlung mehr als einem Pfad (3, 5, 7 und 4, 6, 8) zugeführt. In mindestens einem Pfad wird es vor der Wandlung verstärkt und nach der Wandlung abgeschwächt. Dann wird gemäss einem vorgegebenen Kriterium das Signal aus einem der Pfade zur Ausgabe ausgewählt.

## Beschreibung

Die Erfindung betrifft ein Verfahren und eine Vorrichtung zur Wandlung eines digitalen Audiosignales in ein analoges Signal.

Bekannterweise wird ein digitales Audiosignal, bevor es beispielsweise einem Mischelement oder einem Lautsprecher zugeführt wird, einem Digital/Analog-Wandler zugeführt, wo es in bekannter Weise gewandelt wird. Das dabei erhaltene analoge Signal weist eine Auflösung und einen Störgeräuschabstand auf, die durch die Leistungsfähigkeit des verwendeten Wandlers limitiert sind. Will man die Auflösung und den Störgeräuschabstand des Wandlers steigern, so kann man bis zu einem gewissen Grad einen leistungsfähigeren und auch teureren Wandler wählen. Allerdings stösst man dabei recht bald an Grenzen, denn es gibt weder beliebig hochauflösende Wandler noch solche mit beliebig kleinem Störgeräusch. Sowohl eine hohe Auflösung wie auch ein kleines Störgeräusch sind bei Audiosignalen wünschbar.

Die Erfindung, wie sie in den Ansprüchen gekennzeichnet ist, löst deshalb die Aufgabe, ein Verfahren und eine Vorrichtung der genannten Art zu schaffen, mit denen die Auflösung und der Störgeräuschabstand bei der Wandlung des digitalen Audiosignales in ein analoges Audiosignal unter Verwendung von konventionellen Wandlern erhöht werden kann.

Dies wird dadurch erreicht, dass das digitale Audiosignal zur Wandlung beispielsweise zwei Pfaden zugeführt wird, wobei das Signal im einen Pfad vor der Wandlung digital verstärkt und nach der Wandlung analog abgeschwächt wird, und dass gemäss einem vorgegebenen Kriterium das Signal aus einem der Pfade zur Ausgabe ausgewählt wird.
Dieses Verfahren wird in einer Vorrichtung realisiert, die aus einer Serieschaltung von einer Signal-Aufbereitungsschaltung, von Digital/Analog-Wandlern und mindestens eines Umschalters besteht.

Die durch die Erfindung erreichten Vorteile sind insbesondere darin zu sehen, dass es damit möglich ist, die Auflösung und den Störgeräuschabstand der gewandelten digitalen Signale zu erhöhen. Dieser Vorteil kann aber auch dazu benützt werden, vorgegebene Anforderungen mit relativ einfachen und billigen Digital/Analog-Wandern zu erfüllen. Durch die Erfindung kann auch vorgegeben werden, in welchem Bereich die Auflösung der Signale insbesondere zu verbessern ist. Dies ist vorzugsweise für schwache Signale der Fall. Es kann aber vorgegeben werden, bis zu welcher Amplitude des Signales dies geschehen soll.

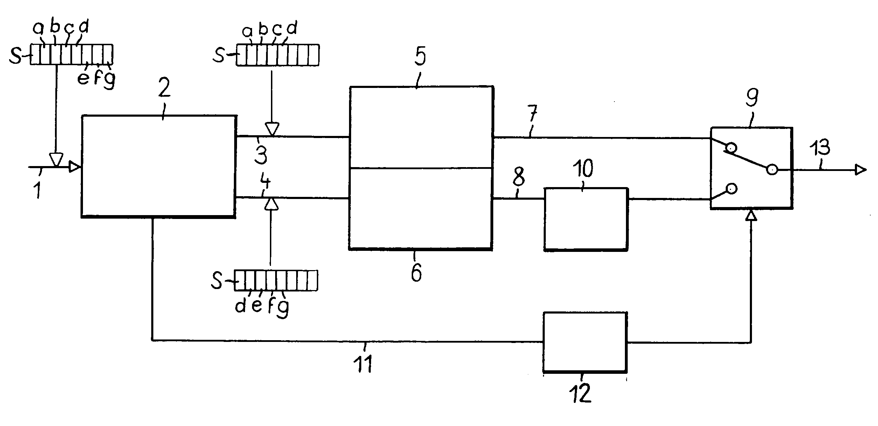

Im folgenden wird die Erfindung anhand von einer einen Ausführungsweg darstellenden Figur näher erläutert. Die Figur zeigt eine schematische Darstellung der erfindungsgemässen Vorrichtung. Das gezeigte Beispiel bezieht sich auf die Verwendung zweier Pfade. Es ist aber möglich eine grössere Anzahl Pfade zu wählen.

Wie aus der Figur ersichtlich, weist die erfindungsgemässe Vorrichtung einen Eingang 1 auf, über den ein digitales Audiosignal eintrifft, das in ein analoges Audiosignal zu wandeln ist. Der Eingang 1 mündet in eine Signal-Aufbereitungsschaltung 2, die beispielsweise als Rechner ausgebildet und durch einen handelsüblichen Prozessor realisiert werden kann, der digitale Signale mit vorgegebenen Werten vergleichen und Werte verstärken oder erhöhen kann. Die Ausgänge 3 und 4 der Signal-Aufbereitungsschaltung 2 sind je mit einem Digital/Analog-Wandler 5,6 verbunden. Diese können sowohl als zwei getrennte Wandler oder als Zweikanalwandler ausgebildet sein, wie sie für ein Stereosignal verwendet werden. Die Ausgänge 7, 8 dieser Wandler 5, 6 sind an Eingänge eines Umschalters 9 angeschlossen, wobei zwischen dem Ausgang 8 und dem Umschalter 9 ein sogenannter Abschwächer 10 eingeschaltet ist, der vorzugsweise zur Erzielung einer notwendigen Genauigkeit des Abschwächungsfaktors abgleichbar oder fein einstellbar ist. Der Ausgang 3 und der Wandler 5 mit dem Ausgang 7 ergeben einen ersten Pfad für die Verarbeitung des digitalen Signales, während der Ausgang 4 mit dem Wandler 6, dem Ausgang 8 und dem Abschwächer 10 einen weiteren Pfad ergeben. Zur Ansteuerung des Umschalters 9 besteht eine Verbindung 11 zwischen der Signal-Aufbereitungsschaltung 2 und dem Umschalter 9, in die auch eine Verzögerungsschaltung 12 eingeschaltet ist. Der Umschalter 9 weist auch einen Ausgang 13 für die analogen Signale auf.

Zur Erklärung der erfindungsgemässen Vorrichtung und des Verfahrens gelten beispielsweise folgende nachstehende Annahmen:
Das am Eingang 1 eintreffende digitale Audiosignal ist beispielsweise im in der Audiotechnik gebräuchlichen Zweier-Komplement- Format dargestellt. Das Datenwort für unser Beispiel weist eine Wortlänge von acht Bit auf (Sabcdefg), wobei S das Vorzeichenbit und auch das höchstwertige Bit repräsentiert. Ausserdem ist die digitale Verstärkung mit einem Faktor 2³ festgelegt, was einer Verschiebung des digitalen Wortes um drei Bit entspricht.

Die Wirkungsweise der erfindungsgemässen Vorrichtung ist demnach wie folgt:
Erhält die Signal-Aufbereitungsschaltung 2 über den Eingang 1 ein Datenwort Sabcdefg, so wird dieses darin nach gewissen Kriterien untersucht, indem es beispielsweise mit einem vorgegebenen Musterwort oder mit Schwellwerten verglichen wird. In diesem Beispiel wird insbesondere ermittelt, ob die vier höchstwertigen Bit Sabc unter sich identisch sind. Ist dies nicht der Fall, so handelt es sich um ein grosses Audiosignal und der analoge Ausgang des Wandlers 5 wird über den Schalter 9 an den Ausgang 13 der Vorrichtung gelegt. Das ausgegebene analoge Signal hat aber nur eine Auflösung, welche der Qualität des verwendeten Wandlers 5 entspricht. Dies ist kein Nachteil, da es sich um einen hohen Signalpegel handelt und die Auflösung sowie das Störgeräusch des Wandlers gut genug sind.
Hat der Vergleich der vier höchstwertigen Bit (Sabc) in der Signal-Aufbereitungsschaltung 2 ergeben, dass diese alle unter sich identisch sind dass es sich also um ein Datenwort handelt, das ein Signal mit geringer Amplitude darstellt, so wird dieses Datenwort, in der Signal-Aufbereitungsschaltung 2 um den Faktor 2³ digital verstärkt, über den Wandler 6, den Abschwächer 10 und den Umschalter 9 dem Ausgang 13 zugewiesen. Der Wandler 6 wird an seinem Ausgang 8 ein analoges Signal abgeben, dessen Wert oder Auslenkung dem Datenwort Sdefg entspricht. Dieser Wert ist nun um den vorgenannten Faktor zu hoch, so dass das analoge Signal im Abschwächer 10 um diesen Faktor reduziert werden muss, bevor es zum Umschalter 9 gelangt. Dadurch wird einerseits die Amplitude auf den Sollwert gebracht und gleichzeitig das Störgeräusch des Wandlers 6 reduziert.
Um zu verhindern, dass bei periodischen Signalen der Umschalter zu oft betätigt wird, was Schaltklicks verursachen kann, soll vorgesehen sein, dass die Verzögerungsschaltung 12 beim Umschalten des Umschalters 9 in die nicht gezeigte Stellung beispielsweise eine vorgegebene Verzögerungszeit von beispielsweise 30 ms anwendet. Diese Verzögerungszeit ist so zu bemessen, dass sich das menschliche Ohr vom Einfluss grosser Signale (grosse Lautstärke) gerade noch nicht erholt hat und eben noch nicht in der Lage ist, schwache Störgeräusche zu erkennen. So lässt sich die Zahl der Einschwingvorgänge und Pegelsprünge im Ausgangssignal reduzieren und es ergeben sich weniger hörbare Störungen die sich als sogenannte Klicks oder in einem erhöhten Klirrfaktor äussern.
Erscheint in der Signal-Aufbereitungsschaltung 2 ein Datenwort mit einem genügend grossen Wert, so wird der Umschalter 9 sofort, ohne Verzögerung, in die gezeigte Stellung geschaltet. Trifft ein Datenwort mit geringem Wert am Eingang 1 ein, so werden weitere Datenwörter mit geringem Wert abgewartet, bis der Umschalter 9 umgestellt wird, welche mit Hilfe von Schwellwerten oder mit einem Musterwort identifiziert werden.
Im ganzen Verfahren oder in der Vorrichtung erfährt das Vorzeichen S eine Sonderbehandlung, indem es immer unverändert übernommen wird und durch Verschiebungen der einzelnen Bit eines Datenwortes nicht betroffen ist.
Das in der Signal-Aufbereitungsschaltung 2 digital verstärkte Signal kann bei grossen Signalen übersteuern. Bekannte, nicht erfindungsgemässe Massnahmen müssen einen sogenannten Wrap-around Effekt verhindern.
Der Umschalter 9 kann in gewissen Fällen zur Vermeidung von Umschaltklicks auch durch einen Ueberblendregler ersetzt werden.
Eine Erweiterung des gezeigten Prinzips auf mehr als zwei Pfade ist möglich. Die genannten Vorteile werden durch eine solche Massnahme noch verstärkt.

## Patentansprüche

1. Verfahren zur Wandlung eines digitalen Audiosignales in ein analoges Signal, dadurch gekennzeichnet, dass das digitale Signal zur Wandlung mehr als einem Pfad (3, 5, 7 und 4, 6, 8, 10) zugeführt wird, dass das Signal in mindestens einem Pfad vor der Wandlung verstärkt und nach der Wandlung abgeschwächt wird und dass gemäss einem vorgegebenen Kriterium das Signal aus einem der Pfade zur Ausgabe ausgewählt wird.

2. Verfahren nach Anspruch 1, dadurch gekennzeichnet, dass zur Verstärkung niederwertige Bit eines Datenwortes an die Stelle von höherwertigen Bit verschoben werden.

3. Verfahren nach Anspruch 1, dadurch gekennzeichnet, dass die digitale Verstärkung und die analoge Abschwächung um einen gleichen Faktor erfolgt.

4. Verfahren nach Anspruch 1, dadurch gekennzeichnet, dass die Ausgabe der Signale aus dem einen Pfad erst nach einer vorgegebenen Verzögerung erfolgt.

5. Vorrichtung zur Durchführung des Verfahrens nach Anspruch 1, gekennzeichnet durch eine Serieschaltung einer Signal-Aufbereitungsschaltung (2), von Digital/Analog-Wandlern (5, 6) und eines Umschalters (9).

6. Vorrichtung nach Anspruch 5, dadurch gekennzeichnet, dass Digital/Analog-Wandler als Mehrfacheinheiten ausgebildet sind.

7. Vorrichtung nach Anspruch 5, dadurch gekennzeichnet, dass ein Ausgang (8) eines Digital/Analog-Wandlers mit einem Abschwächer (10) verbunden ist.

8. Vorrichtung nach Anspruch 5, dadurch gekennzeichnet, dass die Signal-Aufbereitungsschaltung (2) über eine Verzögerungsschaltung (12) mit dem Umschalter (9) zu dessen Ansteuerung verbunden ist.

9. Vorrichtung nach Anspruch 5, dadurch gekennzeichnet, dass der Umschalter (9) durch einen Ueberblendregler ausgebildet ist.

10. Vorrichtung nach Anspruch 5, dadurch gekennzeichnet, dass die Signal-Aufbereitungsschaltung (2) zur Verstärkung des digitalen Audiosignales ausgebildet ist.
